# EUROPEAN PATENT SPECIFICATION

(11) **EP 3 550 544 B1**
(45) Date of publication and mention of the grant of the patent: **05.05.2021**
(21) Application number: 18855186.5
(22) Date of filing: 06.02.2018
(51) Int. Cl.: G09F 9/40, G09F 9/00, G09F 9/33, G09F 9/302

(54) **MULTI-DISPLAY SYSTEM AND VIDEO DISPLAY DEVICE**
MEHRFACHANZEIGESYSTEM UND VIDEOANZEIGEVORRICHTUNG
SYSTÈME À AFFICHAGE MULTIPLE ET DISPOSITIF D'AFFICHAGE VIDÉO

(43) Date of publication of application: 09.10.2019
(73) Proprietor: MITSUBISHI ELECTRIC CORPORATION, Chiyoda-ku Tokyo 100-8310 (JP)
(72) Inventor: NAKANO, Yuzo, Tokyo 1008310 (JP)
(74) Representative: Pfenning, Meinig & Partner mbB
(86) International application number: PCT/JP2018/003947
(87) International publication number: WO 2019/155510

(56) References cited:
- CN-U- 205 158 821
- JP-A- 2010 019 768
- JP-A- 2016 142 861
- JP-A- 2017 126 059
- JP-A- 2017 126 059
- JP-A- 2017 211 400
- JP-A- 2017 211 400
- JP-A- 2017 506 368
- JP-Y2- H 079 129
- US-A1- 2016 210 886
- US-A1- 2016 210 886
- US-A1- 2016 231 976
- US-B1- 9 182 078

## Description

### Technical field

The present invention relates to a multi display system for displaying video information on a large screen by arranging a plurality of video display apparatuses in a vertical direction and a lateral direction, and to a video display apparatus.

### Background Art

Display tiles configured by using a plurality of display elements such as LEDs are widely used for display of outdoor and indoor advertisements and the like due to the technical development of the display elements and cost reduction. A display apparatus provided with display tiles has been mainly used for display of moving images such as natural images and animations. However, as an indoor use, since the viewing distance becomes shorter as the pixel pitch becomes narrower, a display apparatus having display tiles has come to be used for displaying images on a personal computer in a conference room and for monitoring applications in recent years. In particular, in monitoring applications, personal computer images close to still images are often displayed.

As a display apparatus having display tiles, a surface mount device (SMD) type is the mainstream, in which a small LED display module, formed by mounting an LED display element in a cavity molded with ceramic or resin and solidifying it with a sealing resin, is mounted on a substrate. The SMD type display apparatus has been used as a large video display apparatus having a pixel pitch of 3 mm or more.

However, in recent years, with the background of low cost and high definition of the LED display element, a large-sized video display apparatus configured of a plurality of LED display apparatuses arranged in a tile form, each of which is configured of a high-density mounted product having a pixel pitch of 1 mm to 2 mm or the like, is introduced in the market.

For example, Patent Document 1 and Patent Document 2 disclose constituent elements of an LED display apparatus and a holding method thereof.

In Patent Document 1, a large-sized video display apparatus is configured of a multi-display system including a plurality of LED display tiles. R, G and B LED display elements are mounted on a small LED display module substrate up to the vicinity of the periphery of the module substrate. In order to form a first LED display tile with a plurality of LED display module substrates arranged in a square array, a plurality of LED display module substrates is assembled to have a support structure. A second LED display tile is also assembled to have a support structure similar to the first LED display tile. The first LED display tile and the second LED display tile are assembled to have a support structure in a state where they are in close contact with each other while maintaining a very small gap. For the very small gap, the same dimension as the pixel pitch is required.

Further, in Patent Document 1 and Patent Document 2, the shape of a side surface of the LED display tile is processed into a planar shape. When these LED display tiles are combined to constitute a large screen video display apparatus using a multi display system, side surfaces of the respective LED display tiles are connected so as to be in almost close contact with each other.

In addition, Patent Document 3 discloses a structure in which LED display tiles are connected with each other by using a hook-type connecting member.
JP2017211400A provides a display device that can adjust a position of each display tile.
JP2017126059A provides a display assembly that can be easily attached/detached in maintenance for the front of the display assembly, and a display including the same.
US10495255B2 discloses a mounting and leveling system for an electronic image display device formed of an array of multiple display sections facilitates adjustment of the alignment of adjacent display sections to minimize visible seams between display sections. Some embodiments include one or more magnetically actuated fasteners that facilitate front-access-only installation and adjustment without requiring access to the rear, top, bottom, or sides of the array. Tools for installation and removal of display modules from a front side of the display device are also disclosed. Fasteners for providing a hidden adjustable connection between first and second objects are also disclosed. One such fastener includes a screw having a magnetic head that presents a magnetic moment perpendicular to its axis of rotation.

### Prior Art Documents

### Patent Documents

Patent Document 1: U.S. Patent No. 8,384,616
Patent Document 2: Chinese Patent No. 101937630
Patent Document 3: Chinese Utility Model Registration No. 203644333

### Summary

### Problem to be Solved by the Invention

It is necessary to suppress gaps in the vertical direction and the lateral direction between an LED display tile and another LED display tiles adjacent thereto, and suppress level differences in the back-and-forth direction of the LED display surface, to have the same dimensions as that the pixel pitch such that these gaps and level differences are not noticeable. Moreover, since there is not enough space to work on the rear side of the video display apparatus, it is also necessary to adjust the position of the video display apparatus so that these gaps and level differences are not noticeable from the video display surface side.

In Patent Document 1, each LED display tile is supported by an attachment structure so that the arrangement thereof is not impaired. The attachment structure is arranged so that the gaps between an LED display tile and LED display tiles adjacent thereto in the vertical direction and the lateral direction have the same dimension as that of the pixel pitch. However, since a side surface of the LED display tile is planar, there is a problem that gaps between an LED display tile and another LED display tiles adjacent thereto vary due to mechanical precision such as dimensional tolerance or flatness of the support structure holding the LED display tile.

Further, in Patent Document 2, an LED display module substrate is attached to an LED base component, and a housing frame component and a joint component are attached to the rear surface of the LED base component. The LED display tile configured of these members has a substantially flat side surface. Even in Patent Document 2, when a plurality of LED display tiles is arranged in the vertical direction and the lateral direction, there is a problem that gaps between an LED display tile and another LED display tiles adjacent thereto vary, as in the case of Patent Document 1.

Further, in Patent Document 3, since LED display tiles are connected with each other using a hook-type connecting member, high-precision alignment is required for connecting the LED display tiles with each other in the lateral direction. For this reason, it takes a considerable time to align the LED display tiles.

As described above, in the structures described in Patent Documents 1 to 3, due to variations in processing dimensions of structural parts of the metal housing constituting the LED display tile, warp of the LED display module substrate, or the like, there is a problem that gaps between an LED display tile and another LED display tiles adjacent thereto and level differences in the back-and-forth direction of the LED display surface occur. Such gaps and level differences are recognized as connecting portions, that is, joints between an LED display tile and another LED display tiles adjacent thereto, due to a change in luminance, a change in directivity, or the like, causing deterioration in the video quality.

It is therefore an object of the present invention to provide a technology that enables easy access from both the display surface side and the rear surface side of a video display apparatus, and enables an improvement in video quality by precisely adjusting gaps in the lateral direction and the vertical direction and level differences in the back-and-forth direction in the display surfaces between a video display apparatus and another video display apparatuses adjacent thereto, and fixing them in that state.

### Means to Solve the Problem

A multi display system according to the present invention includes a plurality of video display apparatuses, a support structure that supports the video display apparatuses, and a position adjustment mechanism capable of adjusting a position of each of the video display apparatuses. The position adjustment mechanism includes a joint adjustment mechanism responsible for position adjustment in a vertical direction and a lateral direction of each of the video display apparatuses, and a level difference adjustment mechanism responsible for position adjustment in a back-and-forth direction of each of the video display apparatuses. The level difference adjustment mechanism includes a level difference adjustment member that is rotationally operable, and a positioning pin. The level difference adjustment member is disposed at each of four corner portions on a rear surface of each of the video display apparatuses, and has a magnet. The positioning pin is provided coaxially with a rotation axis of the level difference adjustment member. The joint adjustment mechanism includes: a connecting member disposed at a position, on the support structure, corresponding to each of the four corner portions of each of the video display apparatuses; a laterally movable table movable in a lateral direction on the connecting member; a vertically movable table movable in a vertical direction on the laterally movable table; a contact portion provided at a front end portion of the vertically movable table, made of a magnet or a magnetic material, and capable of being in contact with a surface of the level difference adjustment member on a side of the positioning pin; a hole portion that is formed to extend backward from the contact portion and in which the positioning pin is able to be inserted; a lateral position adjustment mechanism that moves the laterally movable table and the vertically movable table in a lateral direction; a lateral position adjustment knob that is rotationally operable and is connected with the lateral position adjustment mechanism and disposed on the connecting member; a vertical position adjustment mechanism that moves the vertically movable table in a vertical direction; and a vertical position adjustment knob that is rotationally operable and is connected with the vertical position adjustment mechanism and disposed on the laterally movable table. When the laterally movable table and the vertically movable table are moved in a lateral direction via the lateral position adjustment mechanism by rotational operation of the lateral position adjustment knob, each of the video display apparatuses moves in a lateral direction, and when the vertically movable table is moved in a vertical direction via the vertical position adjustment mechanism by rotational operation of the vertical position adjustment knob, each of the video display apparatuses moves in a vertical direction. In a state where the positioning pin is inserted in the hole portion, when a surface of the level difference adjustment member on a side of the positioning pin is stuck to the contact portion by a magnetic force of the magnet, each of the video display apparatuses is fixed to the support structure.

### Effects of the Invention

According to the present invention, it is possible to realize easy access from both the display surface side and the rear surface side of a video display apparatus, and to realize an improvement in video quality by precisely adjusting gaps in the lateral direction and the vertical direction and level differences in the back-and-forth direction in the display surfaces between a video display apparatus and another video display apparatuses adjacent thereto, and fixing them in that state.

Objects, features, aspects, and advantages of the present invention will become more apparent from the following detailed description and the accompanying drawings.

### Brief Description of Drawings

Fig. 1 is a perspective view of a multi display system according to a first embodiment.
Fig. 2 is a perspective view of an LED display tile.
Fig. 3 is an exploded perspective view of an LED display tile and a support structure.
Fig. 4 is a rear perspective view of an LED display tile.
Fig. 5 is a perspective view of a level difference adjustment mechanism.
Fig. 6 is a schematic configuration diagram of a position adjustment mechanism.
Fig. 7 is a schematic configuration diagram of a rack and a pinion.
Fig. 8 is an operation explanatory diagram of a rack and a pinion.
Fig. 9 is an operation explanatory diagram of a position adjustment mechanism.
Fig. 10 is a schematic configuration diagram of a position adjustment mechanism included in a multi display system according to a second embodiment.
Fig. 11 is an operation explanatory diagram of a position adjustment mechanism.
Fig. 12 is a schematic configuration diagram of a position adjustment mechanism at a lower right corner portion.
Fig. 13 is a schematic configuration diagram of a connecting member at an upper left corner portion.
Fig. 14 is a schematic configuration diagram of a latch mechanism.
Fig. 15 is a schematic configuration diagram of another example of a latch mechanism.
Fig. 16 is a schematic configuration diagram of a position adjustment mechanism included in a multi display system according to a third embodiment.
Fig. 17 is an operation explanatory diagram of a position adjustment mechanism.
Fig. 18 is an operation explanatory diagram of position adjustment in the back-and-forth direction of a level difference adjustment mechanism and in the lateral direction and the vertical direction of a joint adjustment mechanism, by magnetic jigs included in a multi display system according to a fourth embodiment.
Fig. 19 is an operation explanatory diagram of position adjustment in a forward direction of a level difference adjustment mechanism by a magnetic jig.
Fig. 20 is an operation explanatory diagram of position adjustment in a backward direction of a level difference adjustment mechanism by a magnetic jig.

### Description of Embodiments

### <First Embodiment>

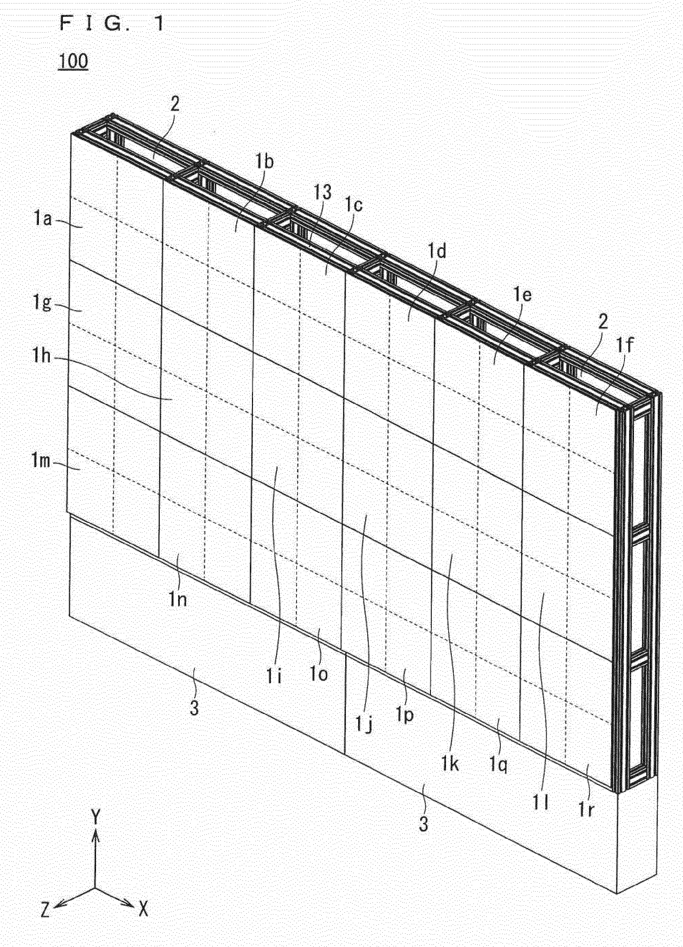

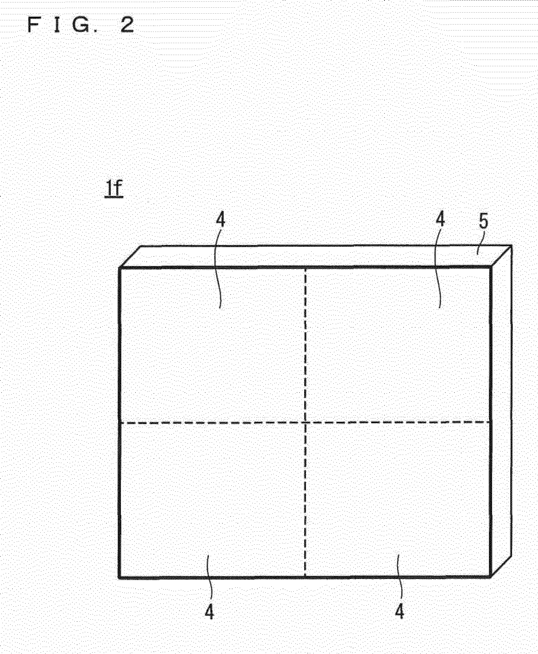

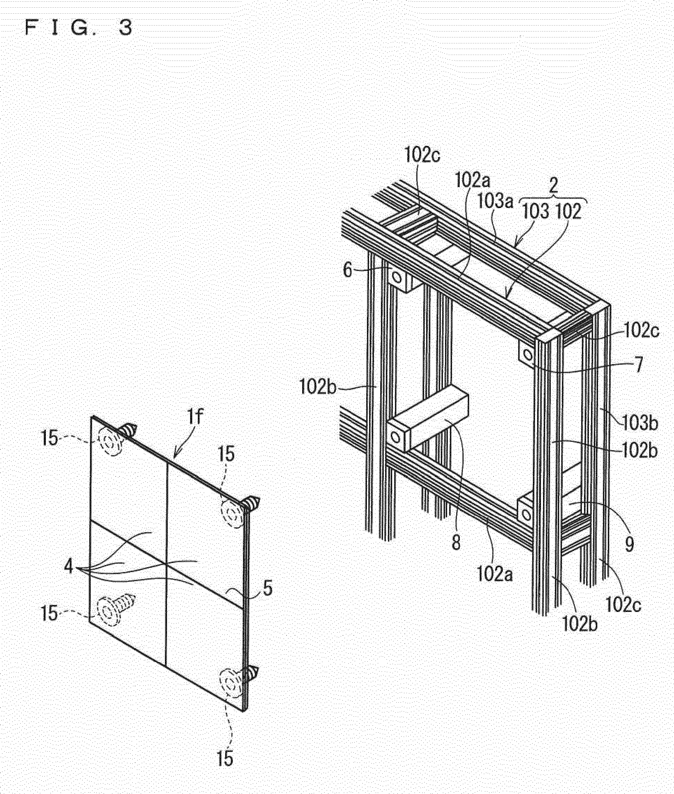

A first embodiment of the present invention will be described below with reference to the drawings. Fig. 1 is a perspective view of a multi display system 100 according to the first embodiment. Fig. 2 is a perspective view of an LED display tile If. Fig. 3 is an exploded perspective view of the LED display tile If and a support structure 2.

As shown in Fig. 1, the multi display system 100 includes a plurality of LED display tiles 1a to 1r, the support structure 2, and a mount 3. Each of the LED display tiles 1a to 1r corresponds to a video display apparatus.

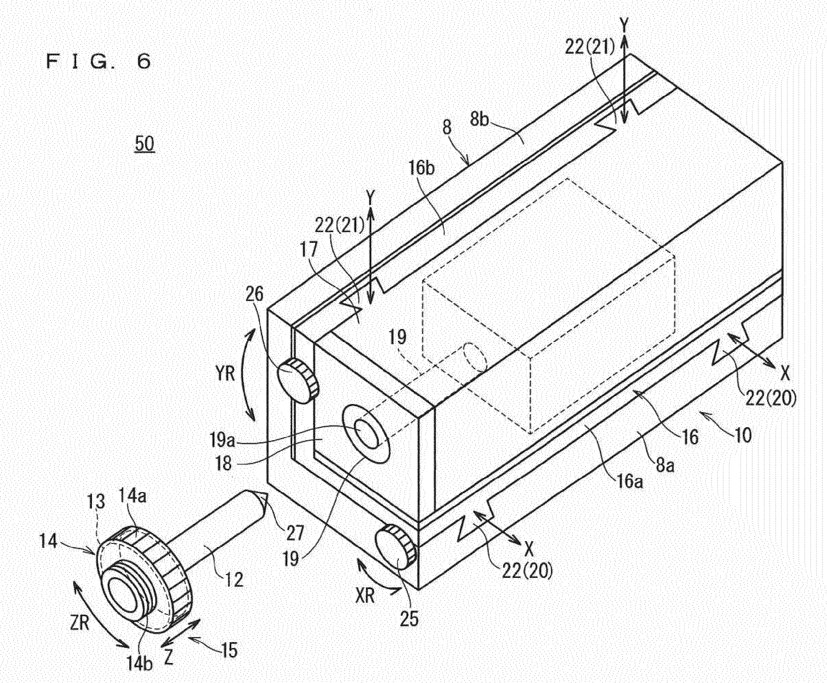

The multi display system 100 also includes a position adjustment mechanism 50 (see Fig. 6).

The multi display system 100 is configured by arranging, for example, eighteen LED display tiles 1a to 1r in the vertical direction and the lateral direction on the mount 3. More specifically, the LED display tiles 1a to 1r are arranged such that three of them are arranged in the vertical direction and six of them are arranged in the lateral direction. Since the eighteen LED display tiles 1a to 1r have the same configuration, the LED display tile If will be described here.

As shown in Fig. 2, the LED display tile If includes four LED module substrates 4 and an LED base 5. The four LED module substrates 4 are arranged such that two of them are in the vertical direction and two of them are in the lateral direction. On each of the four LED module substrates 4, a plurality of LEDs as display elements is squarely arrayed. The LED base 5 is fixed to the rear surfaces of the four LED module substrates 4. The LED base 5 is made of aluminum or magnesium alloy that is a non-magnetic material. The four LED module substrates 4 are precisely adjusted in position with respect to the LED base 5, and are arranged and fixed so that the gap between the LED module substrate 4 and another adjacent LED module substrate 4 is not noticeable.

As shown in FIGS. 2 and 3, the support structure 2 is connected to the rear surface of the LED display tile If, more specifically, to the rear surface of the LED base 5 via corner joints 6, 7, 8, and 9 to thereby support the rear surface of the LED display tile If. The support structure 2 is made of aluminum which is a non-magnetic material. The corner joints 6, 7, 8, and 9 are disposed at positions corresponding to the four corner portions of the rear surface of the LED display tile If. The support structure 2 is configured by assembling two rear surface frames 102 and 103 in a rectangular frame shape in the front and the back. The rear surface frame 102 and the rear surface frame 103 are fixed by a plurality of frames 102c extending in the back-and-forth direction. The frames 102c are arranged around the corner joints 6, 7, 8, and 9. It should be noted that the back-and-forth direction is the "Z-axis direction" in Fig. 1. The corner joints 6, 7, 8 and 9 correspond to connecting members.

Next, the rear surface frame 102 will be described. As shown in Fig. 3, the rear surface frame 102 is a front side frame, and includes a frame 102a extending in the lateral direction and a frame 102b extending in the vertical direction. It should be noted that the lateral direction is the "X-axis direction" of Fig. 1 and the vertical direction is the "Y-axis direction" of Fig. 1.

Next, the rear surface frame 103 will be described. The rear surface frame 103 is a back side frame, and includes a frame 103a extending in the lateral direction and a frame 103b extending in the vertical direction.

In addition, inside the LED base 5 constituting the rear surfaces of the LED display tiles 1a to 1r, an LED display drive circuit, a power supply, and the like are housed. The configurations thereof are the same as the conventional configurations and therefore the details thereof are omitted.

As shown in Fig. 3, the corner joints 6, 7, 8, and 9 are fixed to a frame 102e connecting the rear surface frame 102 and the rear surface frame 103 with fixing screws (not shown). Thereby, the frames constituting the support structure 2 are tightly connected. The frames 102a, 102b, 102c, 202a, and 202b are extrusion frames having the same cross-sectional shape and different lengths. The support structure 2 can be configured inexpensively by combining a plurality of extrusion frames.

The corner joints 6, 7, 8, and 9 are arranged at positions corresponding to the four corner portions of the LED display tile If in the support structure 2. More specifically, the corner joint 6 is disposed at a position corresponding to the upper left corner portion of the LED display tile If in the support structure 2. The corner joint 7 is disposed at a position corresponding to the upper right corner portion of the LED display tile If in the support structure 2. The corner joint 8 is arranged at a position corresponding to the lower left corner portion of the LED display tile If in the support structure 2. The corner joint 9 is arranged at a position corresponding to the lower right corner portion of the LED display tile If in the support structure 2.

In the present embodiment, the corner joint 8 is provided with a joint adjustment mechanism 10 which is a part of a position adjustment mechanism 50, and the corner joint 9 is provided with a joint adjustment mechanism 11 which is a part of the position adjustment mechanism 50. The corner joints 8 and 9 have a role of connecting frames, a role as a strength member of the support structure 2, and a position adjustment function in the vertical direction and the lateral direction of the LED display tile If, in an attempt to reduce the number of components and to reduce manufacturing cost. In the present embodiment, the joint adjustment mechanisms 10 and 11 are provided to the corner joints 8 and 9 respectively. However, the joint adjustment mechanisms may be provided to the corner joints 6 and 7 respectively, instead of the corner joints 8 and 9.

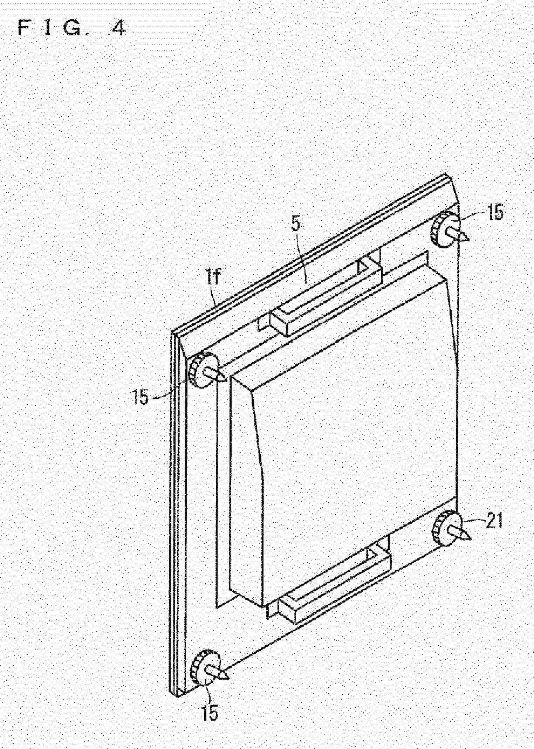

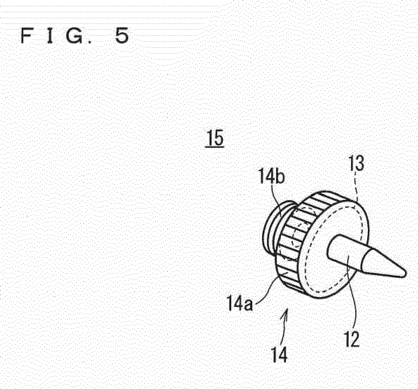

Next, the rear surface structure of the LED display tiles 1a to 1r will be described. Fig. 4 is a rear surface perspective view of the LED display tile 1a. Fig. 5 is a perspective view of a level difference adjustment mechanism 15. Since the eighteen LED display tiles 1a to 1r have the same configuration, the LED display tile 1a will be described here.

As shown in Fig. 4, four level difference adjustment mechanisms 15 are provided at the four corner portions of the rear surface of the LED base 5. The level difference adjustment mechanism 15 is a part of the position adjustment mechanism 50. Here, the position adjustment mechanism 50 will be briefly described.

The position adjustment mechanism 50 is capable of adjusting the positions of the LED display tiles 1a to 1r, and is provided with the joint adjustment mechanisms 10 and 11 and the level difference adjustment mechanism 15. The joint adjustment mechanisms 10 and 11 are responsible for adjusting the positions of the LED display tiles 1a to 1r in the lateral direction and the vertical direction. The level difference adjustment mechanism 15 is responsible for adjusting the positions of the LED display tiles 1a to 1r in the back-and-forth direction.

As shown in Figs. 4 and 5, the level difference adjustment mechanism 15 includes a level difference adjustment member 14, a magnet 13, and a positioning pin 12. The level difference adjustment member 14 is in a disk shape, and an operation part 14a is provided on the outer peripheral portion of the level difference adjustment member 14. The operation part 14a is provided for a user to rotate the level difference adjustment member 14 by pinching it with fingers. A front surface of the level difference adjustment member 14 is provided with a male screw 14b projecting forward. A rear surface of the level difference adjustment member 14 is provided with a positioning pin 12. The positioning pin 12 protrudes rearward from the rear surface on the central axis of the level difference adjustment member 14. That is, the positioning pin 12 is provided coaxially with the rotational axis of the level difference adjustment member 14. The positioning pin 12 also has a conical portion 27 provided at the tip portion.

Four screw holes (not shown) are provided at the four corners of the rear surface of the LED base 5, respectively, and the four level difference adjustment mechanisms 15 are attached to the rear surface of the LED base 5 with the male screws 14b being screwed into the screw holes of the rear surface of the LED base 5, respectively. The level difference adjustment member 14 of each of the four level difference adjustment mechanisms 15 has a magnet 13 incorporated therein. In this way, since the four level difference adjustment mechanisms 15 are attached to the four corner portions of the rear surface of the LED base 5, they can be accessed from respective side surfaces of the LED base 5.

Next, a method of attaching the LED display tile 1a to the support structure 2 will be described. Fig. 6 is a schematic configuration diagram of the position adjustment mechanism 50. Here, since the joint adjustment mechanism 10 provided to the corner joint 9 at the lower right corner portion is symmetrical to the joint adjustment mechanism 10 provided to the corner joint 8 at the lower left corner portion, description will be given only on the joint adjustment mechanism 10 provided to the corner joint 8 at the lower left corner portion.

As shown in Fig. 6, the joint adjustment mechanism 10 includes the corner joint 8, a laterally movable table 16, a vertically movable table 17, a contact portion 18, a hole portion 19a, a lateral position adjustment mechanism 20, a lateral position adjustment knob 25 that is rotationally operable, a vertical position adjustment mechanism 21, and a vertical position adjustment knob 26 that is rotationally operable.

The corner joint 8 has a bottom surface portion 8a and a left side surface portion 8b, and is L-shaped as viewed from the front. The laterally movable table 16 has a bottom surface portion 16a and a left side surface portion 16b, and is L-shaped as viewed from the front. The laterally movable table 16 is disposed on the corner joint 8, and is movable in the lateral direction on the corner joint 8. The laterally movable table 16 is provided with a lateral position adjustment mechanism 20, and a plurality of racks 22 extending in the lateral direction which is a part of the lateral position adjustment mechanism 20 is provided on the lower surface of the laterally movable table 16.

The vertically movable table 17, in a rectangular parallelepiped shape, is disposed on the laterally movable table 16, and is capable of moving the laterally movable table 16 in the vertical direction. The contact portion 18 is provided at a front end portion of the vertically movable table 17. The contact portion 18 is made of a magnet or a magnetic material, and can be brought into contact with a surface of the level difference adjustment member 14 on the positioning pin 12 side. A front portion of the vertically movable table 17 has a cylindrical portion 19 having a hole portion 19a into which the positioning pin 12 can be inserted. More specifically, the cylindrical portion 19 is disposed in a state where the hole portion 19a faces frontward and rearward, and the hole portion 19a extends backward from the contact portion 18. The vertically movable table 17 is provided with a vertical position adjustment mechanism 21. On the left side surface of the vertically movable table 17, a plurality of racks 22 extending in the vertical direction, which is a part of the vertical position adjustment mechanism 21, is provided.

The lateral position adjustment knob 25 is connected to the lateral position adjustment mechanism 20, and is attached to the corner joint 8. The vertical position adjustment knob 26 is connected to the vertical position adjustment mechanism 21 and is attached to the laterally movable table 16. Further, a magnet is incorporated in each of the lateral position adjustment knob 25 and the vertical position adjustment knob 26.

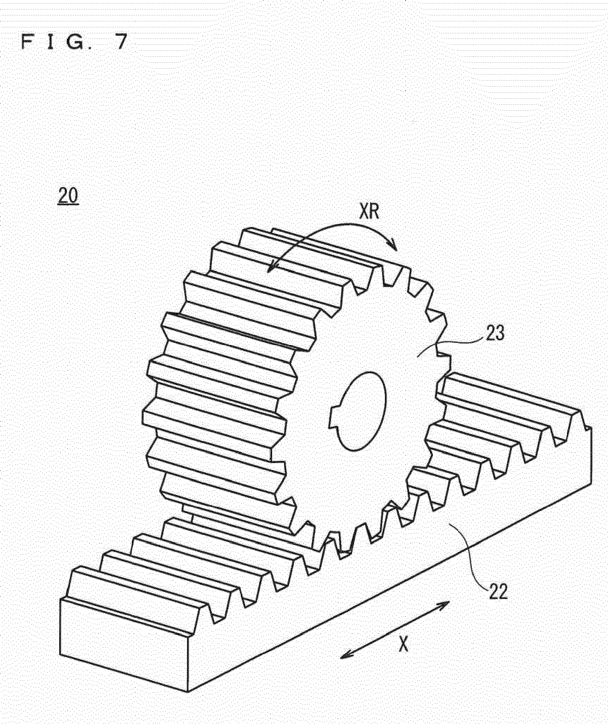

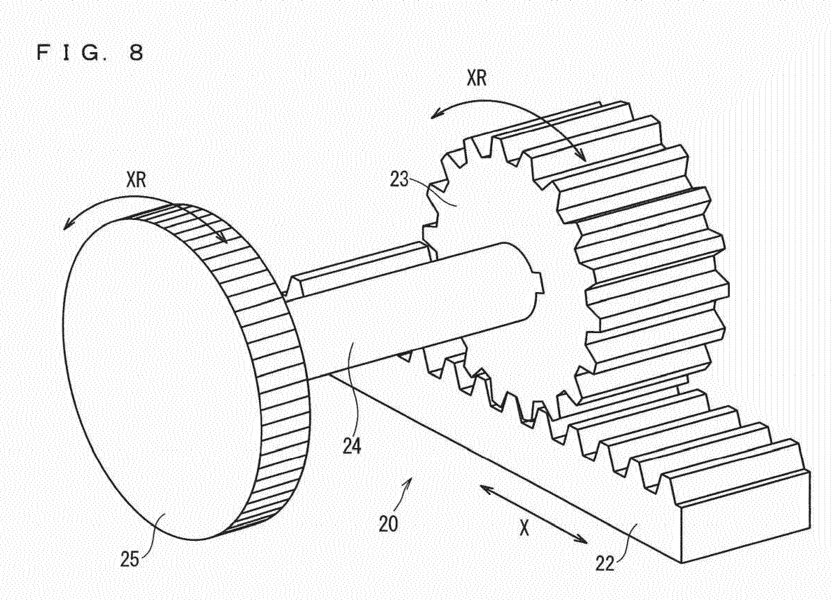

Next, the lateral position adjustment mechanism 20 and the vertical position adjustment mechanism 21 will be described with use of Figs. 7 and 8. Fig. 7 is a schematic configuration diagram of a rack 22 and a pinion 23. Fig. 8 is an operation explanatory diagram of the rack 22 and the pinion 23. Although the lateral position adjustment mechanism 20 includes a plurality of racks 22 and a plurality of pinions 23, one rack 22 and one pinion 23 are shown in Figs. 7 and 8. Since the lateral position adjustment mechanism 20 and the vertical position adjustment mechanism 21 have the same configuration, only the lateral position adjustment mechanism 20 will be described.

As shown in Figs. 6 to 8, the rack 22 is provided on the lower surface of the laterally movable table 16. The pinion 23 is arranged on the lower side of the rack 22 and is meshed with the rack 22. The lateral position adjustment knob 25 is connected to the pinion 23 via a connecting pin 24. Actually, the lateral position adjustment knob 25 is connected to the plurality of pinions 23 via the connecting pin 24. Further, the lateral position adjustment knob 25 is disposed at a position facing the four corner portions of the LED base 5. By rotating the lateral position adjustment knob 25 in the XR direction, the pinion 23 connected via the connecting pin 24 rotates, and the rack 22 meshed with the pinion 23 horizontally moves in the lateral direction.

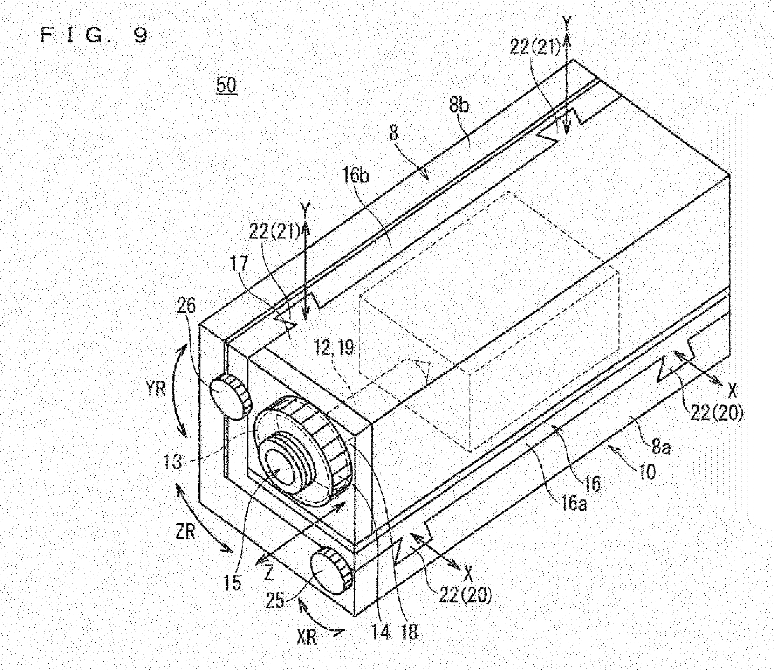

Fig. 9 is an operation explanatory diagram of the position adjustment mechanism 50. As shown in Fig. 9, the positioning pin 12 of the level difference adjustment mechanism 15 is inserted in the hole portion 19a of the joint adjustment mechanism 10. At this time, after the positioning pin 12 provided to the level difference adjustment member 14 incorporating the magnet 13 is guided to the hole portion 19a of the joint adjustment mechanism 10, the level difference adjustment member 14 is held in a state of being stuck to the contact portion 18 by the magnetic force.

Next, when the lateral position adjustment knob 25 of the lateral position adjustment mechanism 20 accessible from the bottom side of the LED base 5 is rotationally operated in the XR direction, the rotation of the lateral position adjustment knob 25 is transmitted to the pinion 23 via the connecting pin 24, as shown in Figs. 7 and 8. The rotation is converted into a linear movement of the rack 22 of the laterally movable table 16 meshed with the pinion 23, and the laterally movable table 16 moves in the lateral direction. At the same time, the vertically movable table 17 disposed on the laterally movable table 16 also moves in the lateral direction.

Next, when the vertical position adjustment knob 26 of the vertical position adjustment mechanism 21 accessible from the side surface side of the LED base 5 is rotationally operated in the YR direction, the rotation is transmitted to the pinion 23 via the connecting pin 24. The rotation is converted into a linear movement of the rack 22 of the vertically movable table 17 meshed with the pinion 23, the vertically movable table 17 moves in the vertical direction, and the positioning pin 12 of the level difference adjustment mechanism 15 inserted in the cylindrical portion 19 provided to the vertically movable table 17 simultaneously moves in the vertical direction.

As described above, through rotational operation of the lateral position adjustment knob 25 accessible from the bottom surface side of the LED base 5 and the vertical position adjustment knob 26 accessible from the side surface side, the cylindrical portion 19 moves in the vertical direction and the lateral direction, and the positioning pin 12 of the level difference adjustment mechanism 15 inserted in the cylindrical portion 19 moves in the vertical direction and the lateral direction. Thereby, among the four corner portions of the LED base 5 to which the level difference adjustment mechanism 15 is attached, the position in the vertical direction and the lateral direction of the lower left corner portion is first adjusted.

Similarly, with respect to the joint adjustment mechanism 11 provided to the corner joint 9 at the lower right corner portion, through rotational operation of the lateral position adjustment knob 25 and the vertical position adjustment knob 26, the position in the vertical direction and the lateral direction of the lower right corner portion of the LED base 5 is adjusted.

As described above, through the rotational operation of the lateral position adjustment knob 25 and the vertical position adjustment knob 26 provided to the corner joints 8 and 9 at two corner portions, it is possible to adjust the position in the vertical direction and the lateral direction of the LED display tile. This enables adjustment of the gaps that are joint widths in the vertical direction and the lateral direction between the LED display tile and another LED display tiles adjacent thereto.

Through rotational operation of the operation part 14a of the level difference adjustment member 14 attached to the four corner portions of the rear surface of the LED base 5, the gaps between the rear surface of the LED base 5 and the contact portion 18 of each of the joint adjustment mechanisms 10 and 11 and the contact portion of each of the corner joints 6 and 7 can be adjusted. As a result, the positions in the back-and-forth direction of the four corner portions of the LED display tile 1 are adjusted.

Next, a method of installing the LED display tiles 1a to 1r constituting the multi display system 100 will be described. As shown in Fig. 1, Fig. 3, and Fig. 9, first, the lateral position adjustment knob 25 and the vertical position adjustment knob 26 are adjusted by rotational operation such that the cylindrical portions 19 of the joint adjustment mechanisms 10 and 11 arranged at the position of the support structure 2 opposed to the LED display tile 1m, for example, which is the position reference tile at the time of installation, are positioned at the reference positions in the vertical direction and the horizontal direction, respectively.

Next, the positioning pins 12 of the level difference adjustment mechanisms 15, attached to the four corner portions of the rear surface of the LED base 5 of the LED display tile 1m, are guided by the conical portions 27 thereof to the cylindrical portions 19 provided to the joint adjustment mechanisms 10 and 11 and the corner joints 6 and 7, respectively. At this time, the positioning pins 12 are guided toward the center direction of the cylindrical portions 19, and the level difference adjustment members 14 are stuck by the magnetic force to the contact portions 18 of the joint adjustment mechanisms 10 and 11 and the contact portions of the corner joints 6 and 7 made of a magnetic material. Thereby, the LED display tile 1m is held at the reference position in the vertical direction and the lateral direction. Further, through rotational operation of the operation part 14a of the level difference adjustment member 14, the LED display tile 1m is adjusted to the reference position in the back-and-forth direction.

After the LED display tile 1m serving as the position reference tile is installed, the LED display tiles In, 1o, 1p, 1q, and 1r adjacent thereto, on the first row, are sequentially installed while being adjusted such that the joint widths in the vertical direction and the lateral direction and the level differences in the back-and-forth direction are not noticeable in the same manner as described above, with respect to the joint adjustment mechanisms 10 and 11 and the level difference adjustment mechanisms 15. Further, the LED display tiles 1g, 1h, 1i, 1j, 1k, and 11 on the second row and the LED display tiles 1a, 1b, 1c, 1d, 1e, and If on the third row are sequentially installed similarly, through adjustment of the joint widths in the lateral direction and adjustment of the level differences in the back-and-forth direction.

Although description has been given by taking the multi display system 100 configured of eighteen surfaces as an example in the embodiment, it is possible to perform similar assembly adjustment even in the case of a multi display system having a larger number of LED display tiles. Even if the multi display system is large, since the joints of the display surface can be finely adjusted by the same adjustment procedure as this, joints between the LED display tiles are less noticeable, and it is possible to provide a video with unity.

As described above, in the multi display system 100 according to the first embodiment, when the laterally movable table 16 and the vertically movable table 17 are moved in the lateral direction via the lateral position adjustment mechanism 20 by the rotational operation of the lateral position adjustment knob 25, the LED display tiles 1a to 1r are moved in the lateral direction, and when the vertically movable table 17 is moved in the vertical direction via the vertical position adjustment mechanism 21 by the rotational operation of the vertical position adjustment knob 26, the LED display tiles 1a to 1r are moved in the in the vertical direction. Further, when the surface of the level difference adjustment member 14 on the side of the positioning pin 12 is stuck to the contact portion 18 by the magnetic force of the magnet 13 in a state where the positioning pin 12 is inserted in the hole portion 19a, the display LED tiles 1a to 1r are fixed to the support structure 2.

Therefore, by precisely adjusting the gaps in the lateral direction and the vertical direction and the level differences in the back-and-forth direction of the display surfaces between an LED display tile and another LED display tiles adjacent thereto and fixing them in that state, it is possible to improve the quality of the video.

Since the lateral position adjustment knob 25 and the vertical position adjustment knob 26 are provided to the corner joints 8 and 9 disposed at positions corresponding to the corner portions of the LED display tiles 1a to 1r in the support structure 2, even in an environment where it is difficult to access from the rear surface side of the LED display tiles 1a to 1r, by drawing out each of the LED display tiles 1a to 1r forward not only from the rear surface side but also from the front surface side of each LED display tile 1a to 1r, it is possible to easily access the joint adjustment mechanisms 10 and 11. That is, it is possible to easily access the joint adjustment mechanisms 10 and 11 from both the display surface side and the rear surface side of the LED display tiles 1a to 1r.

### <Second embodiment

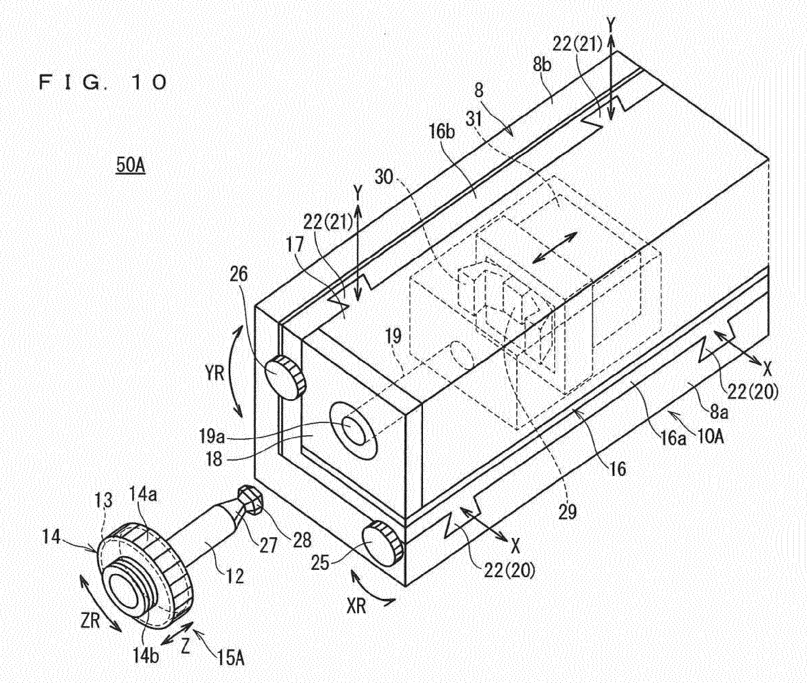

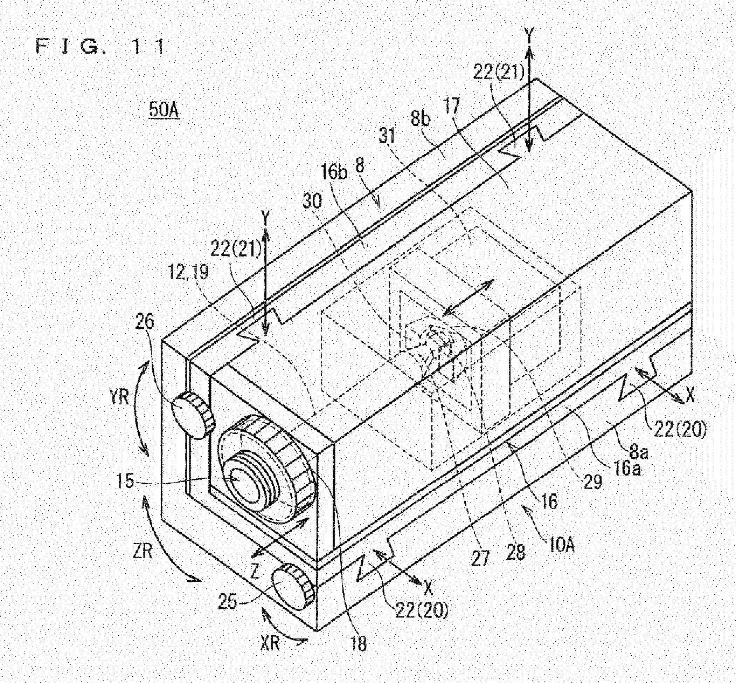

Next, a multi display system 100 according to a second embodiment will be described. Fig. 10 is a schematic configuration diagram of a position adjustment mechanism 50A included in the multi display system 100 according to the second embodiment. Fig. 11 is an operation explanatory diagram of the position adjustment mechanism 50A. In the second embodiment, the same constituent elements as those described in the first embodiment are denoted by the same reference numerals, and the description thereof will be omitted.

As shown in Figs. 10 and 11, in the second embodiment, the shape of the positioning pin 12 is different from that of the first embodiment. Specifically, the positioning pin 12 has a protruded portion 28 provided at the tip end portion and a conical portion 27 provided at the base end side thereof.

Furthermore, the vertically movable table 17 further includes a latch mechanism 31 that fixes and unfixes the protruded portion 28, to and from the depth side of the cylindrical portion 19. The latch mechanism 31 includes two claw portions 30 capable of holding the protruded portion 28 between them and a push/pull mechanism 29 for switching opening and closing of the two claw portions 30. The two claw portions 30 are arranged on the left and right sides of the push/pull mechanism 29. Since the hole portion 19a of the cylindrical portion 19 and the push/pull mechanism 29 are positioned on the same straight line, the protruded portion 28 of the positioning pin 12 can perform pushing operation on the push/pull mechanism 29.

As shown in Fig. 11, in the push/pull mechanism 29, the two claw portions 30 are closed in conjunction with the pushing operation performed by the protruded portion 28 of the positioning pin 12. Thereby, since the protruded portion 28 is fixed by the two claw portions 30, it is possible to eliminate backlash in the back-and-forth direction when the protruded portion 28 and the latch mechanism 31 are fitted. Further, as shown in Fig. 10, when a deeper pushing operation is performed by the protruded portion 28 of the positioning pin 12, the push/pull mechanism 29 returns to the front side whereby the two claw portions 30 are opened in conjunction with the return of the push/pull mechanism 29 to the front side. Thereby, fixing of the protruded portion 28 by the two claw portions 30 is released.

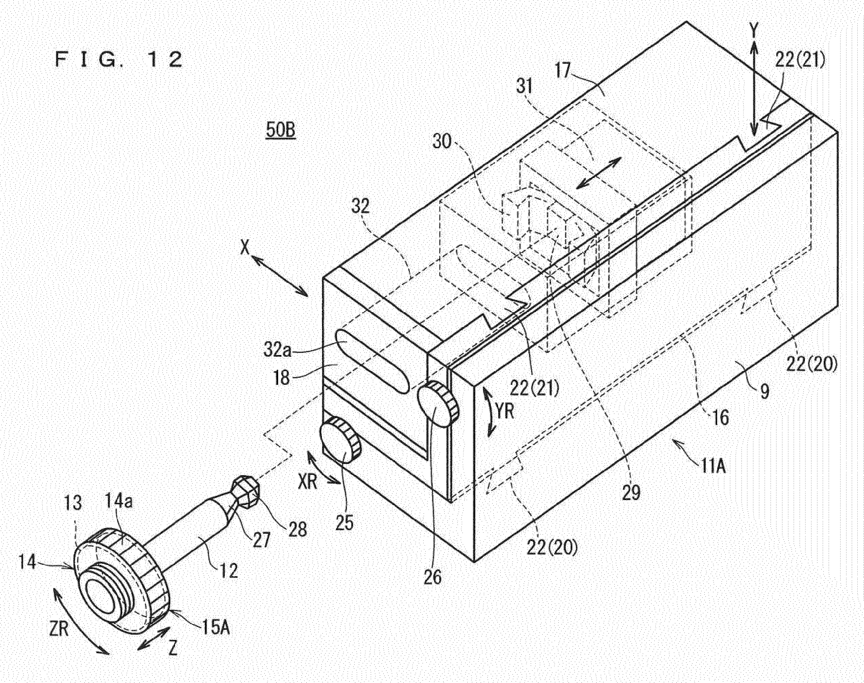

Next, a position adjustment mechanism 50B provided to the corner joint 9 at the lower right corner portion will be described. Fig. 12 is a schematic configuration diagram of the position adjustment mechanism 50B at the lower right corner portion.

In the second embodiment, the configurations of the position adjustment mechanism 50A at the lower left corner portion and the position adjustment mechanism 50B at the lower right corner portion are different from each other. As shown in Fig. 12, the vertically movable table 17 has a long cylindrical portion 32 instead of the cylindrical portion 19. The long cylindrical portion 32 is disposed in a state where a hole portion 32a which is a long hole extending in the lateral direction faces frontward and backward.

As the position adjustment mechanism 50B at the lower right corner portion has the long cylindrical portion 32, regarding the position adjustment of the LED display tiles 1a to 1r in the lateral direction, mainly, when adjusting the position of the LED display tiles 1a to 1r in the lateral direction by the rotational operation of the lateral position adjustment knob 25 at the lower left corner portion that is performed first, the positioning pin 12 of the position adjustment mechanism 50B at the lower right corner portion can move in the hole portion 32a of the long cylindrical portion 32 in the lateral direction, so that no stress is applied to the long cylindrical portion 32. Thereby, it is possible to smoothly adjust the positions of the LED display tiles 1a to 1r in the lateral direction.

Next, through adjustment of the position in the vertical direction and the position in the back-and-forth direction of the lower right corner portion in the similar procedure by rotational operation of the vertical position adjustment knob 26 and the level difference adjustment member 14, the positions of the lower sides of the LED display tiles 1a to 1r in the vertical direction, in the lateral direction, and in the back-and-forth direction are determined.

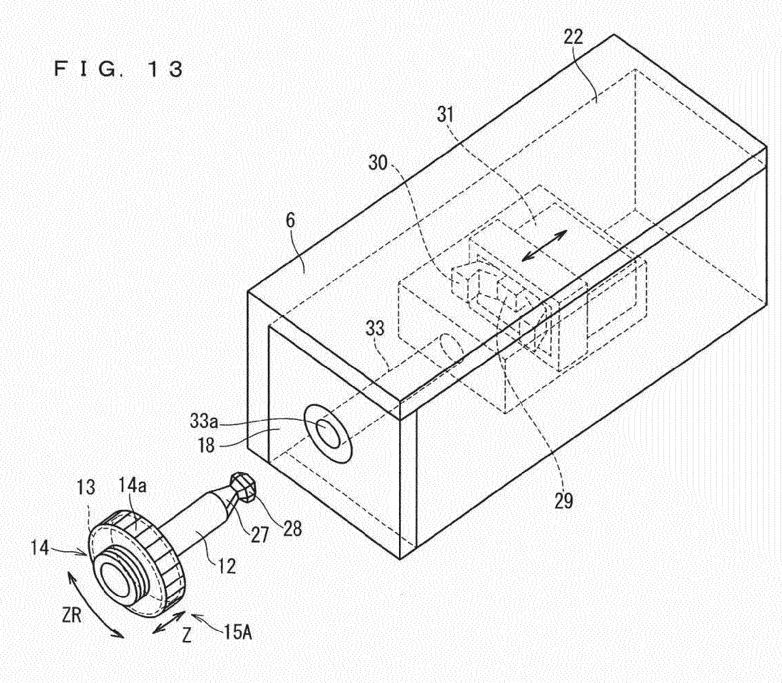

Fig. 13 is a schematic configuration diagram of the corner joint 6 at the upper left corner portion. As shown in Fig. 13, the corner joint 6 has a rectangular parallelepiped shape, and a contact portion 18 is disposed at the front end portion of the corner joint 6. In a front portion of the corner joint 6, a cylindrical portion 33 having a hole portion 33a into which the positioning pin 12 can be fitted is disposed. The hole portion 33a of the cylindrical portion 33 has a larger diameter than that of a hole portion 19a of the cylindrical portion 19. This is because the component size and mounting variation of the LED base 5 are taken into consideration. This makes it possible to omit the joint adjustment mechanisms 10 and 11 in the corner joint 6 at the upper left corner portion and the corner joint 7 at the upper right corner portion, to thereby reduce the member cost.

The corner joint 6 further includes a latch mechanism 31 on the depth side of the cylindrical portion 33. The corner joint 7 of the upper right corner portion is symmetrical to the corner joint 6 of the upper left corner portion shown in Fig. 10. Therefore, it is not shown.

As described above, in the multi display system 100 according to the second embodiment, the positioning pin 12 has the protruded portion 28 provided at the tip end portion thereof, the vertically movable table 17 further includes the latch mechanism 31 for fixing and unfixing the protruded portion 28 on the depth side of the hole portions 19a and 32a, and the latch mechanism 31 includes claw portions 30 capable of holding the protruded portion 28 between them and the push/pull mechanism 29 for switching opening and closing of the claw portions 30. The LED display tiles 1a to 1r are fixed to and unfixed from the support structure 2 by fixing and unfixing the protruded portion 28 by pushing operation of the level difference adjustment mechanism 15 with respect to the push/pull mechanism 29.

Therefore, in addition to stick by the magnetic force between the level difference adjustment member 14 and the contact portion 18, the protruded portion 28 can be held by the claw portions 30. Accordingly, the fixed state between the LED display tiles 1a to 1r and the support structure 2 is maintained.

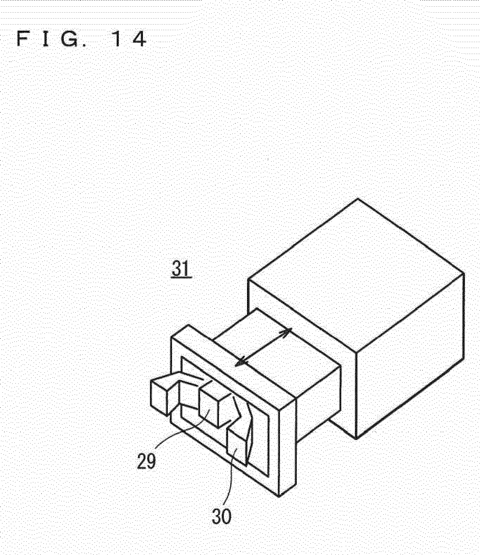

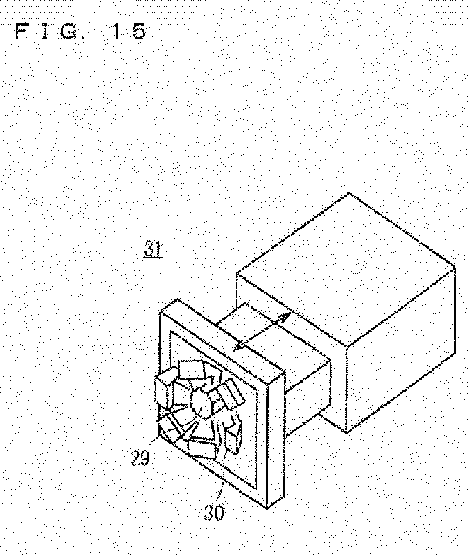

As shown in Fig. 14, in the present embodiment, the latch mechanism 31 has been described as having two claw portions 30. However, it is not limited thereto. The latch mechanism 31 may have three or more claw portions 30. Fig. 14 is a schematic configuration diagram of the latch mechanism 31. Fig. 15 is a schematic configuration diagram of another example of the latch mechanism 31.

For example, as shown in Fig. 15, six claw portions 30 are disposed while being equally spaced around the push/pull mechanism, and can hold the protruded portion 28 so as to firmly wrap around it. Since the protruded portion 28 can be strongly held by the six claw portions 30 in addition to the stick by the magnetic force between the level difference adjustment member 14 and the contact portion 18, even if a strong external force is applied by an earthquake or the like, the fixed state between each of the LED display tiles 1a to 1r and the support structure 2 is maintained.

### <Third embodiment>

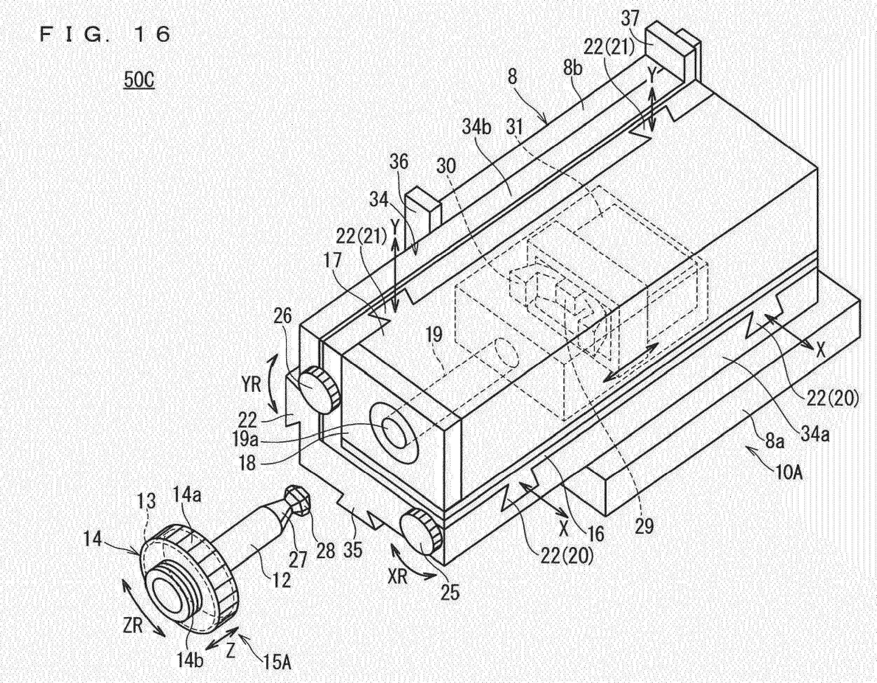

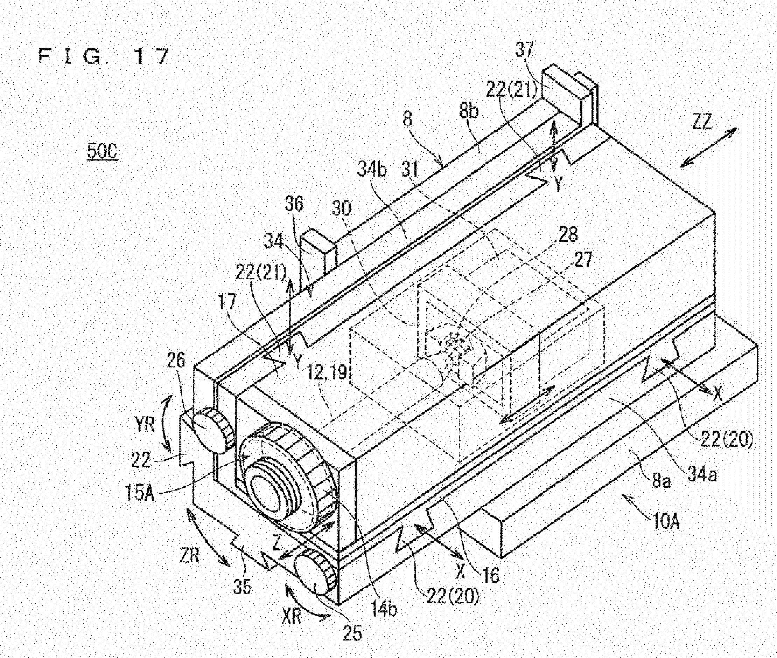

Next, a multi display system 100 according to a third embodiment will be described. Fig. 16 is a schematic configuration diagram of a position adjustment mechanism 50C included in the multi display system 100 according to the third embodiment. Fig. 17 is an operation explanatory diagram of the position adjustment mechanism 50C. In the third embodiment, the same constituent elements as those described in the first and second embodiments are denoted by the same reference numerals, and the description thereof will be omitted.

In the third embodiment, as shown in Figs. 16 and 17, a joint adjustment mechanism 10A further includes a back-and-forth movable table 34. The back-and-forth movable table 34 has a bottom surface portion 34a and a left side surface portion 34b, and is L-shaped as viewed from the front. The back-and-forth movable table 34 is arranged on the corner joint 8. Each of the bottom surface portion 34a and the left side surface portion 34b has one sliding portion 35 extending in the back-and-forth direction, and one groove portion (not shown) is provided at a position, corresponding to the sliding portion 35, in each of the bottom surface portion 8a and the left side surface portion 8b of the corner joint 8. The sliding portion 35 slides along the groove portion, so that the back-and-forth movable table 34 is movable in the back-and-forth direction on the corner joint 8.

The laterally movable table 16 is disposed on the back-and-forth movable table 34, and is movable on the back-and-forth movable table 34 in the lateral direction.

When fixing each of the LED display tiles 1a to 1r to the support structure 2, the back-and-forth movable table 34 is moved forward, and the positioning pin 12 is inserted into the hole portion 19a, and in a state where the surface of the level difference adjustment member 14 on the positioning pin 12 side is stuck to the contact portion 18 by the magnetic force of the magnet 13, the back-and-forth movable table 34 is moved backward. As a result, since the position adjustment mechanism 50C is accessible in a state where each of the LED display tiles 1a to 1r is moved forward by the back-and-forth movable table 34, the position adjustment mechanism 50C can be easily accessed.

Further, the front end portion of the left side surface portion 8b of the corner joint 8 has a stopper 36, and the rear end portion of the left side surface portion 34b of the back-and-forth movable table 34 has a hook portion 37. Thereby, when the back-and-forth movable table 34 is drawn forward, the hook portion 37 abuts against the stopper 36 and the back-and-forth movable table 34 cannot be drawn any more. Therefore, it is possible to prevent the back-and-forth movable table 34 from falling off.

As described above, in the multi display system 100 according to the third embodiment, when each of the LED display tiles 1a to 1r is fixed to the support structure 2, the back-and-forth movable table 34 is moved forward to thereby insert the positioning pin 12 into the hole portion 19a, and in a state where the surface of the level difference adjustment member 14 on the side of the positioning pin 12 is stuck to the contact portion 18 by the magnetic force of the magnet 13, the back-and-forth movable table 34 is moved backward. As a result, since the position adjustment mechanism 50C is accessible in a state where each of the LED display tiles 1a to 1r is moved forward by the back-and-forth movable table 34, the position adjustment mechanism 50C can be easily accessed.

Note that the multi display system 100 according to the first embodiment may employ the back-and-forth movable table 34. Even in that case, the same effect as that of the third embodiment can be obtained.

### <Fourth embodiment

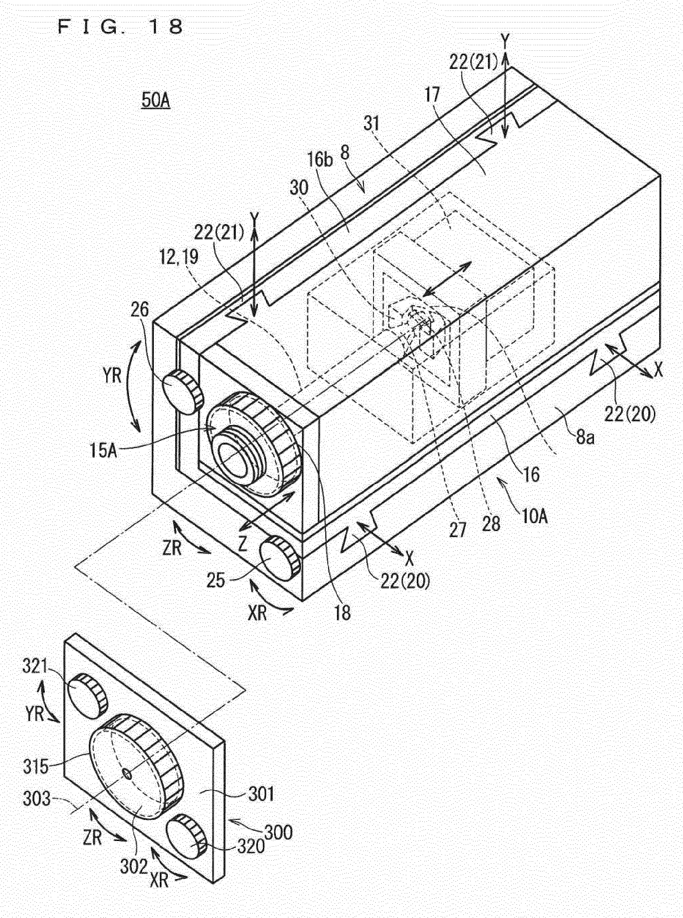

Next, a multi display system 100 according to a fourth embodiment will be described. Fig. 18 is an operation explanatory diagram of position adjustment in the back-and-forth direction of the level difference adjustment mechanism 15 and in the lateral direction and the vertical direction of the joint adjustment mechanism 10A by a magnetic jig 300 provided to the multi display system 100 according to the fourth embodiment. In the fourth embodiment, the same constituent elements as those described in the first to third embodiments are denoted by the same reference numerals, and the description thereof will be omitted.

As shown in Fig. 18, in the fourth embodiment, the multi display system 100 further includes the magnetic jig 300. The magnetic jig 300 is disposed on the display surface of the LED display tile 1a at a position corresponding to the position adjustment mechanism 10A on the rear surface side. The magnetic jig 300 is provided with a protective resin layer 301 subjected to antistatic treatment and magnet rotating portions 302, 320, and 321 rotatable with respect to the protective resin layer 301. In the fourth embodiment, a case where the magnetic jig 300 is employed in the multi display system 100 according to the second embodiment will be described.

In the case of adjusting the position in the back-and-forth direction of the LED display tile 1a, the protective resin layer 301 of the magnetic jig 300 is brought into contact with the display surface of the LED display tile 1a, and in a state where the magnet 13 in the level difference adjustment member 14 screwed on the LED base 5 on the rear surface side of the LED display tile 1a and the magnet rotating portion 302 are stuck by the magnetic force, the magnet rotating portion 302 is rotated.

In the case of adjusting the position of the LED display tile 1a in the lateral direction, in a state where the lateral position adjustment knob 25 on the rear surface side of the LED display tile 1a and the magnet rotating portion 320 are stuck to each other by the magnetic force, the magnet rotating portion 320 is rotated. In the case of adjusting the position of the LED display tile 1a in the vertical direction, in a state where the vertical position adjustment knob 26 on the rear surface side of the LED display tile 1a and the magnet rotating portion 321 are stuck to each other by the magnet force, the magnet rotating portion 321 is rotated.

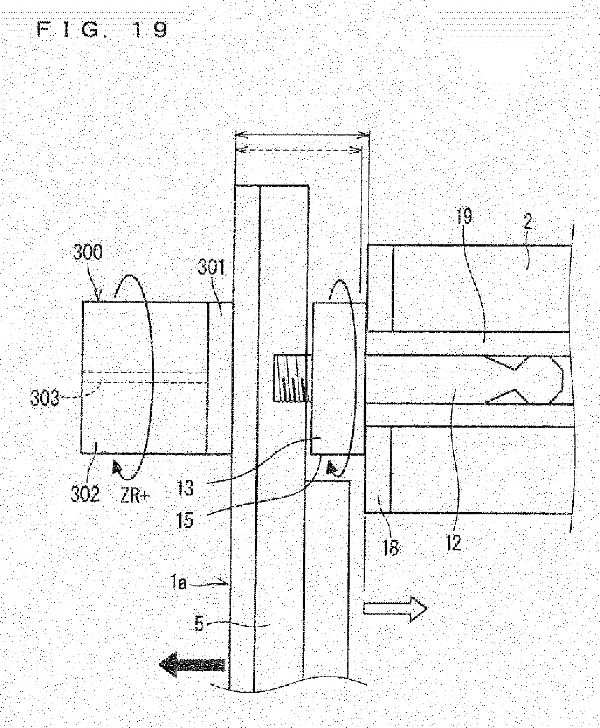

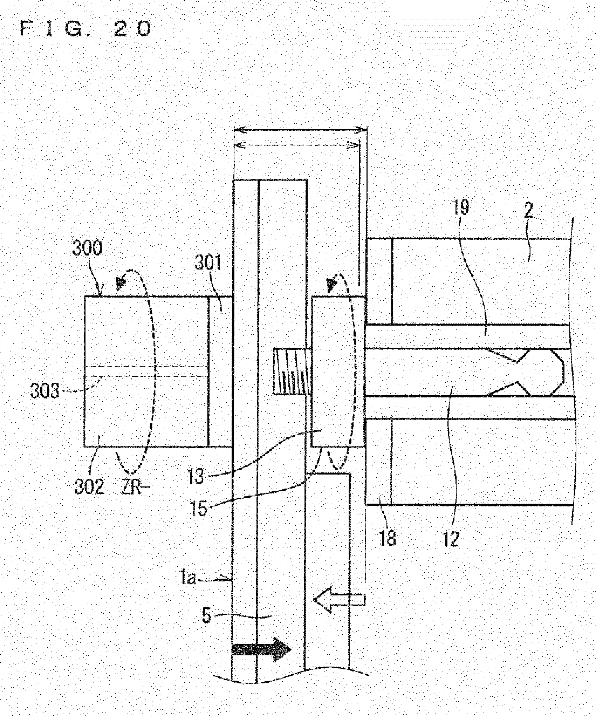

Next, the details of the position adjustment method of the LED display tile 1a in the back-and-forth direction using the magnetic jig 300 will be described. Fig. 19 is an operation explanatory diagram of position adjustment in the forward direction of the level difference adjustment mechanism 15A by the magnetic jig 300. Fig. 20 is an operation explanatory diagram of position adjustment in the backward direction of the level difference adjustment mechanism 15A by the magnetic jig 300.

As shown in Fig. 19, the protective resin layer 301 of the magnetic jig 300 is brought into contact with the display surface of the LED display tile 1a, and in a state where the magnet 13 in the level difference adjustment member 14 screwed on the LED base 5 on the rear surface side of the LED display tile 1a and the magnet rotating portion 302 are stuck to each other by the magnetic force, the magnet rotating portion 302 is rotated in a clockwise direction about the rotational axis 303. Then, since the level difference adjustment member 14 rotates in a direction of being let out, the level difference adjustment member 14 relatively moves to the side opposite to the LED display tile 1a, the distance between the contact portion 18 and the LED display tile 1a becomes long, and the LED display tile 1a moves forward.

As shown in Fig. 20, in a state where the protective resin layer 301 of the magnetic jig 300 is brought into contact with the display surface of the LED display tile 1a, and the magnet 13 in the level difference adjustment member 14 screwed on the LED base 5 on the rear surface side of the LED display tile 1a and the magnet rotating portion 302 are stuck to each other by the magnetic force, the magnet rotating portion 302 is rotated in a counterclockwise direction about the rotational axis 303. Then, since the level difference adjustment member 14 rotates in a direction of being fastened, the level difference adjustment member 14 moves relatively to the side of the LED display tile 1a, the distance between the contact portion 18 and the LED display tile 1a becomes short, and the LED display tile 1a moves backward.

Thereby, as shown in Fig. 1, even in a state where the multi display system 100 is assembled and there is no work space on the rear surface, through rotational operation of the magnetic jig 300 performed from the front side of the LED display tiles 1a to 1r, it is possible to perform adjustment so as to eliminate the level difference in the back-and-forth direction between an LED display tile and another LED display tiles adjacent thereto.

Similarly, through rotational operation of the magnet rotating portion 320 and the magnet rotating portion 321 from the front surface side of the LED display tiles 1a to 1r, it is possible to perform adjustment so as to eliminate the gaps in the lateral direction and the vertical direction between an LED display tile and another LED display tiles adjacent thereto.

As described above, in the multi display system 100 according to the fourth embodiment, both the lateral position adjustment knob 25 and the vertical position adjustment knob 26 have magnets, and the multi display system 100 further includes the magnetic jig 300 that can stick, by the magnetic force, the level difference adjustment member 14, the lateral position adjustment knob 25, and the vertical position adjustment knob 26. The magnetic jig 300 is disposed on the display surface of each of the LED display tiles 1a to 1r, and through rotational operation in a state where the level difference adjustment member 14, the lateral position adjustment knob 25, and the vertical position adjustment knob 26 are stuck by the magnetic force of the magnetic jig 300 from the display surface side of each of the LED display tiles 1a to 1r via each of the LED display tiles 1a to 1r, the position of each of the LED display files 1a to 1r in the back-and-forth direction, in the lateral direction, and in the vertical direction is adjusted.

Accordingly, without rotational operation of the level difference adjustment member 14, the lateral position adjustment knob 25, and the vertical position adjustment knob 26 directly by the manual operation, it is possible to individually adjust the position in the back-and-forth direction, the lateral direction, and the vertical direction of each of the LED display tiles 1a to 1r through rotational operation by the magnetic force. Thereby, even in an environment where it is difficult to access from the rear surface side after assembling the multi display system 100, joints and level differences between an LED display tile and another LED display tiles adjacent thereto can be adjusted by the magnetic jig 300 with precision from the front surface side.

In the fourth embodiment, description has been given on the case of employing the magnetic jig 300 in the multi display system 100 according to the second embodiment. However, it is also possible to employ the magnetic jig 300 in the multi display system 100 according to the first and third embodiments. Even in that case, the same effect as that of the fourth embodiment can be achieved.

Although the present invention has been described in detail, the above description is illustrative in all aspects, and the present invention is not limited thereto. It is understood that innumerable modifications not illustrated can be envisaged without departing from the scope of the present invention.

In the present invention, the respective embodiments can be freely combined or appropriately modified or omitted within the scope of the present invention.

### Explanation of Reference Signs

1a to 1r: LED display tile
2: support structure
6, 7, 8, 9: corner joint
10, 10A, 11: joint adjustment mechanism
12: positioning pin
14: level difference adjustment member
15, 15A: level difference adjustment mechanism
16: laterally movable table
17: vertically movable table
18: contact portion
19a: hole portion
20: lateral position adjustment mechanism
21: vertical position adjustment mechanism
25: lateral position adjustment knob
26: vertical position adjustment knob
28: protruded portion
29: push/pull mechanism
30: claw portion
31: latch mechanism
32a: hole portion
34: back-and-forth movable table
50, 50A, 50B, 50C: position adjustment mechanism
100: multi display system
300: magnetic jig

## Claims

1. A multi display system comprising:
a plurality of video display apparatuses (1a to 1r);
a support structure (2) that supports the plurality of video display apparatuses (1a to 1r); and
a position adjustment mechanism (50, 50A, 50B) capable of adjusting a position of each of the plurality of the video display apparatuses (1a to 1r), wherein
the position adjustment mechanism (50, 50A, 50B) includes a joint adjustment mechanism (10, 11) responsible for position adjustment in a vertical direction and a lateral direction of each of the plurality of video display apparatuses (1a to 1r), and a level difference adjustment mechanism (15, 15A) responsible for position adjustment in a back-and-forth direction of each of the plurality of video display apparatuses (1a to 1r),
the level difference adjustment mechanism (15, 15A) includes a level difference adjustment member (14) that is rotationally operable and a positioning pin (12), the level difference adjustment member (14) being disposed at each of four corner portions on a rear surface of each of the plurality of video display apparatuses (1a to 1r) and having a magnet, the positioning pin (12) being provided coaxially with a rotational axis of the level difference adjustment member (14),
the joint adjustment mechanism (10, 11) includes: a connecting member (6, 7, 8, 9) disposed at a position, on the support structure (2), corresponding to each of the four corner portions of each of the plurality of video display apparatuses (1a to 1r); a laterally movable table (16) movable in a lateral direction on the connecting member (6, 7, 8, 9); a vertically movable table (17) movable in a vertical direction on the laterally movable table (16), having a front end portion and a rear end portion, wherein a surface of the front end portion faces to a rear surface side of the plurality of video display apparatuses (1a to 1r), and a surface of the rear end portion faces away from the rear surface side of the plurality of video display apparatuses (1a to 1r); a contact portion (18) provided at the front end portion of the vertically movable table (17), made of a magnet or a magnetic material, and capable of being in contact with a surface of the level difference adjustment member (14) on a side of the positioning pin (12); a hole portion (19a, 32a) that is formed to extend from the contact portion (18) towards the rear end portion of the vertically movable table (17) and in which the positioning pin (12) is able to be inserted; a lateral position adjustment mechanism (20) that moves the laterally movable table (16) and the vertically movable table (17) in a lateral direction; a lateral position adjustment knob (25) that is rotationally operable, the lateral position adjustment knob (25) being connected with the lateral position adjustment mechanism (20) and being disposed on the connecting member (6, 7, 8, 9); a vertical position adjustment mechanism (21) that moves the vertically movable table (17) in a vertical direction; and a vertical position adjustment knob (26) that is rotationally operable, the vertical position adjustment knob (26) being connected with the vertical position adjustment mechanism (21) and being disposed on the laterally movable table (16),
when the laterally movable table (16) and the vertically movable table (17) are moved in a lateral direction via the lateral position adjustment mechanism (20) by rotational operation of the lateral position adjustment knob (25), each of the plurality of video display apparatuses (1a to 1r) moves in a lateral direction, and when the vertically movable table (17) is moved in a vertical direction via the vertical position adjustment mechanism (21) by rotational operation of the vertical position adjustment knob (26), each of the plurality of video display apparatuses (1a to 1r) moves in a vertical direction, and
in a state where the positioning pin (12) is inserted in the hole portion (19a, 32a), when a surface of the level difference adjustment member (14) on a side of the positioning pin (12) is stuck to the contact portion (18) by a magnetic force of the magnet, each of the plurality of video display apparatuses (1a to 1r) is fixed to the support structure (2).

2. The multi display system according to claim 1, wherein
each of the lateral position adjustment knob (25) and the vertical position adjustment knob (26) has a magnet,
the multi display system further includes a magnetic jig (300) capable of sticking the level difference adjustment member (14), the lateral position adjustment knob (25), and the vertical position adjustment knob (26) by a magnetic force, and
the magnetic jig (300) is disposed on a display surface of each of the plurality of video display apparatuses (1a to 1r), and through rotational operation in a state where the level difference adjustment member (14), the lateral position adjustment knob (25), and the vertical position adjustment knob (26) are stuck via each of the plurality of video display apparatuses (1a to 1r) by the magnetic force of the magnetic jig (300) from a side of the display surface of each of the plurality of video display apparatuses (1a to 1r), a position of each of the plurality of video display apparatuses (1a to 1r) in a back-and-forth direction, a lateral direction, and a vertical direction is adjusted.

3. The multi display system according to claim 1, wherein
the positioning pin (12) has a protruded portion (28) provided at a tip end portion,
the vertically movable table (17) further includes, on an inner side of the hole portion (19a, 32a), a latch mechanism (31) that performs fixing and unfixing of the protruded portion (28), and
the latch mechanism (31) includes claw portions (30) capable of holding the protruded portion (28) between the claw portions (30), and a push/pull mechanism (29) that performs switching between open and close of the claw portions (30), and when fixing and unfixing of the protruded portion (28) are performed by a pushing operation of the level difference adjustment mechanism (15, 15A) with respect to the push/pull mechanism (29), each of the plurality of video display apparatuses (1a to 1r) is fixed to and unfixed from the support structure (2).

## Patentansprüche

1. Mehrfachanzeigesystem, umfassend:
eine Vielzahl von Videoanzeigevorrichtungen (1a bis 1r);
eine Trägerstruktur (2), die die Vielzahl von Videoanzeigevorrichtungen (1a bis 1r) trägt; und
einen Positionsanpassungsmechanismus (50, 50A, 50B), der in der Lage ist, eine Position von jeder der Vielzahl der Videoanzeigevorrichtungen (1a bis 1r) anzupassen, wobei
der Positionsanpassungsmechanismus (50, 50A, 50B) einen Verbindungsanpassungsmechanismus (10, 11) enthält, der für Positionsanpassung in einer vertikalen Richtung und einer lateralen Richtung von jeder der Vielzahl von Videoanzeigevorrichtungen (1a bis 1r) verantwortlich ist, und einen Niveaudifferenz-Anpassungsmechanismus (15, 15A), der für Positionsanpassung in einer Rückwärts- und Vorwärtsrichtung von jeder der Vielzahl von Videoanzeigevorrichtungen (1a bis 1r) verantwortlich ist,
der Niveaudifferenz-Anpassungsmechanismus (15, 15A) ein Niveaudifferenz-Anpassungselement (14), das drehbar betätigbar ist, und einen Positionierungsstift (12) aufweist, wobei das Niveaudifferenz-Anpassungselement (14) an jedem von vier Eckabschnitten auf einer hinteren Oberfläche von jeder der Vielzahl von Videoanzeigevorrichtungen (1a bis 1r) angeordnet ist und einen Magneten aufweist, wobei der Positionierungsstift (12) koaxial mit einer Drehachse des Niveaudifferenz-Anpassungselements (14) vorgesehen ist,
wobei der Verbindungsanpassungsmechanismus (10, 11) aufweist: ein Verbindungselement (6, 7, 8, 9), das an einer Position auf der Trägerstruktur (2) angeordnet ist, die jedem der vier Eckabschnitte von jeder der Vielzahl von Videoanzeigevorrichtungen (1a bis 1r) entspricht; einen lateral bewegbaren Tisch (16), der in einer lateralen Richtung auf dem Verbindungselement (6, 7, 8, 9) bewegbar ist; einen vertikal bewegbaren Tisch (17), der in einer vertikalen Richtung auf dem lateral bewegbaren Tisch (16) bewegbar ist und einen vorderen Endabschnitt und einen hinteren Endabschnitt aufweist, wobei eine Oberfläche des vorderen Endabschnitts einer hinteren Oberflächenseite der Vielzahl von Videoanzeigevorrichtungen (1a bis 1r) zugewandt ist, und eine Oberfläche des hinteren Endabschnitts von der hinteren Oberflächenseite der Vielzahl von Videoanzeigevorrichtungen (1a bis 1r) abgewandt ist; einen Kontaktabschnitt (18), der an dem vorderen Endabschnitt des vertikal bewegbaren Tisches (17) vorgesehen ist, aus einem Magneten oder einem magnetischen Material hergestellt ist, und in der Lage ist, mit einer Oberfläche des Niveaudifferenz-Anpassungselements (14) auf einer Seite des Positionierungsstifts (12) in Kontakt zu sein; einen Lochabschnitt (19a, 32a), der ausgebildet ist, um sich von dem Kontaktabschnitt (18) zu dem hinteren Endabschnitt des vertikal bewegbaren Tisches (17) hin zu erstrecken und in den der Positionierungsstift (12) eingeführt werden kann; einen Laterale-Position-Anpassungsmechanismus (20), der den lateral bewegbaren Tisch (16) und den vertikal bewegbaren Tisch (17) in einer lateralen Richtung bewegt; einen Laterale-Position-Anpassungsknopf (25), der drehend betätigbar ist, wobei der Laterale-Position-Anpassungsknopf (25) mit dem Laterale-Position-Anpassungsmechanismus (20) verbunden ist und auf dem Verbindungselement (6, 7, 8, 9) angeordnet ist; einen Vertikale-Position-Anpassungsmechanismus (21), der den vertikal bewegbaren Tisch (17) in einer vertikalen Richtung bewegt; und einen Vertikale-Position-Anpassungsknopf (26), der drehend betätigbar ist, wobei der Vertikale-Position-Anpassungsknopf (26) mit dem Vertikale-Position-Anpassungsmechanismus (21) verbunden ist und auf dem lateral bewegbaren Tisch (16) angeordnet ist,
wenn der lateral bewegbare Tisch (16) und der vertikal bewegbare Tisch (17) über den Laterale-Position-Anpassungsmechanismus (20) durch Drehbetätigung des Laterale-Position-Anpassungsknopfes (25) in einer lateralen Richtung bewegt werden, sich jede der Vielzahl von Videoanzeigevorrichtungen (1a bis 1r) in einer lateralen Richtung bewegt, und wenn der vertikal bewegbare Tisch (17) über den Vertikale-Position-Anpassungsmechanismus (21) durch Drehbetätigung des Vertikale-Position-Anpassungsknopfes (26) in eine vertikale Richtung bewegt wird, sich jede der Vielzahl von Videoanzeigevorrichtungen (1a bis 1r) in einer vertikalen Richtung bewegt, und
in einem Zustand, in dem der Positionierungsstift (12) in den Lochabschnitt (19a, 32a) eingeführt ist, wenn eine Oberfläche des Niveaudifferenz-Anpassungselements (14) auf einer Seite des Positionierungsstifts (12) durch eine magnetische Kraft des Magneten an dem Kontaktabschnitt (18) haftet, jede der Vielzahl von Videoanzeigevorrichtungen (1a bis 1r) an der Trägerstruktur (2) fixiert ist.

2. Mehrfachanzeigesystem nach Anspruch 1, wobei
jeder von dem Laterale-Position-Anpassungsknopf (25) und dem Vertikale-Position-Anpassungsknopf (26) einen Magneten aufweist,
das Mehrfachanzeigesystem weiterhin eine magnetische Spannvorrichtung (300) aufweist, die in der Lage ist, das Niveaudifferenz-Anpassungselement (14), den Laterale-Position-Anpassungsknopf (25) und den Vertikale-Position-Anpassungsknopf (26) durch eine magnetische Kraft anzuhaften, und
die magnetische Spannvorrichtung (300) auf einer Anzeigeoberfläche von jeder der Vielzahl von Videoanzeigevorrichtungen (1a bis 1r) angeordnet ist, und durch Drehbetätigung in einem Zustand, in dem das Niveaudifferenz-Anpassungselement (14), der Laterale-Position-Anpassungsknopf (25) und der Vertikale-Position-Anpassungsknopf (26) über jede der Vielzahl von Videoanzeigevorrichtungen (1a bis 1r) durch die magnetische Kraft der magnetischen Spannvorrichtung (300) von einer Seite der Anzeigeoberfläche von jeder der Vielzahl von Videoanzeigevorrichtungen (1a bis 1r) anhaften, eine Position von jeder der Vielzahl von Videoanzeigevorrichtungen (1a bis 1r) in einer Vorwärts- und Rückwärtsrichtung, einer lateralen Richtung und einer vertikalen Richtung angepasst wird.

3. Mehrfachanzeigesystem nach Anspruch 1, wobei
der Positionierungsstift (12) einen vorstehenden Abschnitt (28) aufweist, der an einem Spitzenendabschnitt vorgesehen ist,
der vertikal bewegbare Tisch (17) ferner auf einer Innenseite des Lochabschnitts (19a, 32a) einen Verriegelungsmechanismus (31) aufweist, der Fixieren und Lösen des vorstehenden Abschnitts (28) durchführt, und
der Verriegelungsmechanismus (31) Klauenabschnitte (30), die in der Lage sind, den vorstehenden Abschnitt (28) zwischen den Klauenabschnitten (30) zu halten, und einen Schub/Zug-Mechanismus (29), der Schalten zwischen Öffnen und Schließen der Klauenabschnitte (30) durchführt, aufweist, und wenn Fixieren und Lösen des vorstehenden Abschnitts (28) durch eine Schubbetätigung des Niveaudifferenz-Anpassungsmechanismus (15, 15A) in Bezug auf den Schub/Zug-Mechanismus (29) durchgeführt wird, jede von der Vielzahl von Videoanzeigevorrichtungen (1a bis 1r) an/von der Trägerstruktur (2) fixiert und gelöst wird.

## Revendications

1. Système d'affichage multiple comprenant :
une pluralité d'appareils d'affichage vidéo (1a à 1r) ;
une structure de support (2) qui supporte la pluralité d'appareils d'affichage vidéo (1a à 1r) ; et
un mécanisme de réglage de la position (50, 50A, 50B) pouvant régler la position de chacun de la pluralité d'appareils d'affichage vidéo (1a à 1r), dans lequel
le mécanisme de réglage de la position (50, 50A, 50B) comprend un mécanisme de réglage articulé (10, 11) en charge du réglage de la position dans une direction verticale et dans une direction latérale de chacune de la pluralité d'appareils d'affichage vidéo (1a à 1r), et un mécanisme de réglage d'une différence de niveau (15, 15A) en charge du réglage de la position dans une direction d'avant en arrière de chacun de la pluralité d'appareils d'affichage vidéo (1a à 1r),
le mécanisme de réglage d'une différence de niveau (15, 15A) comprend un élément de réglage d'une différence de niveau (14) qui est fonctionnel en rotation, et une broche de positionnement (12), l'élément de réglage d'une différence de niveau (14) étant disposé au niveau de chacun des quatre parties coins sur une surface arrière de chacun de la pluralité d'appareils d'affichage vidéo (1a à 1r), et présentant un aimant, la broche de positionnement (12) étant disposé coaxialement avec l'axe de rotation de l'élément de réglage d'une différence de niveau (14),
le mécanisme de réglage articulé (10, 11) comprend : un élément connexion (6, 7, 8, 9) disposé en une position, sur la structure de support (2), qui correspond à chacun des quatre parties coins de chacun de la pluralité d'appareils d'affichage vidéo (1a à 1r) ; une tablette mobile latéralement (16) mobile dans une direction latérale sur l'élément connexion (6, 7, 8, 9) ; une tablette mobile verticalement (17) mobile dans une direction verticale sur la tablette mobile latéralement (16), présentant une partie extrémité avant et une partie extrémité arrière, dans lequel une surface de la partie extrémité avant fait face à un côté de la surface arrière de la pluralité d'appareils d'affichage vidéo (1a à 1r), et une surface de la partie extrémité arrière fait face en s'éloignant au côté de la surface arrière de la pluralité d'appareils d'affichage vidéo (1a à 1r) ; une partie contact (18) prévue au niveau de la partie extrémité avant de la tablette mobile verticalement (17), constituée d'un aimant ou d'un matériau magnétique, et qui peut être en contact avec une surface de l'élément de réglage d'une différence de niveau (14) sur un côté de la broche de positionnement (12) ; une partie trou (19a, 32a) qui est formée afin de s'étendre à partir de la partie contact (18) vers la partie extrémité arrière de la tablette mobile verticalement (17), et dans laquelle il est possible d'insérer la broche de positionnement (12) ; un mécanisme de réglage de la position latérale (20) qui déplace la tablette mobile latéralement (16) et la tablette mobile verticalement (17) dans une direction latérale ; un bouton de réglage de la position latérale (25) qui est fonctionnel en rotation, le bouton de réglage de la position latérale (25) étant connecté au mécanisme de réglage de la position latérale (20), et étant disposé sur l'élément connexion (6, 7, 8, 9) ; un mécanisme de réglage de la position verticale (21) qui déplace la tablette mobile verticalement (17) dans une direction verticale ; et un bouton de réglage de la position verticale (26) qui est fonctionnel en rotation, le bouton de réglage de la position verticale (26) étant connecté au mécanisme de réglage de la position verticale (21), et étant disposé sur la tablette mobile latéralement (16) ;
lorsque la tablette mobile latéralement (16) et la tablette mobile verticalement (17) sont déplacées dans une direction latérale par l'intermédiaire du mécanisme de réglage de la position latérale (20) en faisant tourner le bouton de réglage de la position latérale (25), chacun de la pluralité d'appareils d'affichage vidéo (1a à 1r) se déplace dans une direction latérale, et lorsque la tablette mobile verticalement (17) est déplacée dans une direction verticale par l'intermédiaire du mécanisme de réglage de la position verticale (21) en faisant tourner le bouton de réglage de la position verticale (26), chacun de la pluralité d'appareils d'affichage vidéo (1a à 1r) se déplace dans une direction verticale, et
dans un état où la broche de positionnement (12) est insérée dans la partie trou (19a, 32a), quand une surface de l'élément de réglage d'une différence de niveau (14) sur un côté de la broche de positionnement (12) est plaquée à la partie contact (18) par la force magnétique de l'aimant, chacun de la pluralité d'appareils d'affichage vidéo (1a à 1r) est fixé à la structure de support (2).

2. Système d'affichage multiple selon la revendication 1, dans lequel
chacun du bouton de réglage de la position latérale (25) et du bouton de réglage de la position verticale (26) comprend un aimant,
le système d'affichage multiple comprend en outre un montage magnétique (300) pouvant plaquer par une force magnétique, l'élément de réglage d'une différence de niveau (14), le bouton de réglage de la position latérale (25), et le bouton de réglage de la position verticale (26), et
le montage magnétique (300) est disposé sur la surface d'affichage de chacun de la pluralité d'appareils d'affichage vidéo (1a à 1r), et grâce à une rotation dans un état où l'élément de réglage d'une différence de niveau (14), le bouton de réglage de la position latérale (25), et le bouton de réglage de la position verticale (26), sont plaqués par l'intermédiaire de chacun de la pluralité d'appareils d'affichage vidéo (1a à 1r) par la force magnétique du montage magnétique (300) à partir d'un côté de la surface d'affichage de chacun de la pluralité d'appareils d'affichage vidéo (1a à 1r), la position de chacun de la pluralité d'appareils d'affichage vidéo (1a à 1r) dans une direction d'avant en arrière, dans une direction latérale, et dans une direction verticale, est réglée.

3. Système d'affichage multiple selon la revendication 1, dans lequel la broche de positionnement (12) présente une partie en saillie (28) disposée au niveau d'une partie extrémité de bout,
la tablette mobile verticalement (17) comprend en outre, sur un côté intérieur de la partie trou (19a, 32a), un mécanisme de verrouillage (31) qui exécute la fixation et le retrait de la partie en saillie (28), et
le mécanisme de verrouillage (31) comprend des parties griffes (30) pouvant tenir la partie en saillie (28) entre les parties griffes (30), et un mécanisme de poussée / traction (29) qui exécute une commutation entre l'ouverture et la fermeture des parties griffes (30), et lorsque la fixation et le retrait de la partie en saillie (28) sont exécutés par une poussée du mécanisme de réglage d'une différence de niveau (15, 15A) par rapport au mécanisme de poussée / traction (29), chacun de la pluralité d'appareils d'affichage vidéo (1a à 1r) est fixé à la structure de support (2), et détaché de celle-ci.
